# EUROPÄISCHE PATENTSCHRIFT

(11) **EP 3 394 860 B1**
(45) Veröffentlichungstag und Bekanntmachung des Hinweises auf die Patenterteilung: **25.09.2019**
(21) Anmeldenummer: 16806044.0
(22) Anmeldetag: 01.12.2016
(51) Int. Cl.: H01B 3/40, H05K 5/06, H05K 7/14, G01D 11/24, G01F 23/22, C08L 63/00

(54) **FELDGERÄT DER AUTOMATISIERUNGSTECHNIK UND VERFAHREN ZU DESSEN HERSTELLUNG**
FIELD DEVICE FOR AUTOMATION TECHNOLOGY AND METHOD FOR THE PRODUCTION THEREOF
APPAREIL DE TERRAIN DE LA TECHNIQUE DE L'AUTOMATISATION ET SON PROCÉDÉ DE FABRICATION

(30) Priorität: 21.12.2015 DE 102015122435
(43) Veröffentlichungstag der Anmeldung: 31.10.2018
(73) Patentinhaber: Endress+Hauser Flowtec AG, 4153 Reinach (CH)
(72) Erfinder: TSCHUDIN, Beat, 4153 Reinach (CH); GWERDER, Christian, 4203 Grellingen (CH)
(74) Vertreter: Andres, Angelika Maria
(86) Internationale Anmeldenummer: PCT/EP2016/079482
(87) Internationale Veröffentlichungsnummer: WO 2017/108369

(56) Entgegenhaltungen:
- EP-A1- 1 669 726
- EP-A1- 1 717 253
- WO-A1-2008/049660
- DE-A1- 19 839 458

## Beschreibung

Die Erfindung betrifft ein Feldgerät der Automatisierungstechnik nach dem Oberbegriff des Anspruchs 1 und ein Verfahren zu dessen Herstellung.

Vergussmassen werden aus verschiedenen Gründen in einem Feldgerät eingesetzt. Die DE 10 2007 058 608 A1 offenbart ein Feldgerät mit einer Einbettmasse welche kugelförmige mit Gas-befüllte Hohlkörper aufweist. Diese dienen dem Ex-m Schutz.

Feldgeräte können aufgrund des breiten Einsatzgebietes besonders hohen Temperaturschwankungen unterliegen. Dies führt zu Materialausdehungen und Materialschrumpfungen innerhalb des Gehäuses, was zu Fehlmessungen oder im Extremfall zum Ausfall von Elektronikbauteilen führen kann.

Ausgehend von diesem Stand der Technik ist es nunmehr Aufgabe der vorliegenden Erfindung ein Feldgerät und ein Verfahren zu dessen Herstellung bereitzustellen, welche in einem größeren Temperaturbereich nutzbar ist und eine geringere Ausfallquote bei Temperaturwechselbeanspruchung aufweist.

Die Erfindung löst diese Aufgabe durch ein Feldgerät mit den Merkmalen des Anspruchs 1 und durch ein Verfahren mit den Merkmalen des Anspruchs 11.

Ein erfindungsgemäßes Feldgerät der Automatisierungstechnik umfasst einen Messaufnehmer zur Ermittlung eines Messsignals und einem Messumformer zur Ausgabe einer aus dem Messsignal ermittelten physikalischen Größe eines Mediums in einem Behältnis und/oder einem Rohr und/oder einer aus dem Messsignal ermittelten Stoffeigenschaft des Mediums.

Ein Messaufnehmer kann beispielsweise im Fall eines magnetisch-induktiven Durchflussmessgerätes eine umfangsverteilte Anordnung eines Magnetsystems und von Messelektroden an einem Messrohr sein. Das Messsignal ist eine an den Messelektroden abgegriffene Spannung.

Der Messumformer kann aus dieser abgegriffene Spannung in einen Durchfluss oder eine Strömungsgeschwindigkeit des Mediums durch das Messrohr ermitteln. Dies ist dann die physikalische Größe. Bei anderen Feldgeräten kann es sich beispielsweise bei der physikalischen Größe um den Füllstand des Mediums im Behälter handeln oder um den Druck des Mediums oder um die Temperatur des Mediums.

Bei der Stoffeigenschaft des Mediums kann es sich z.B. um die Wärmeleitfähigkeit, die elektrische Leitfähigkeit, die Viskosität, den pH-Wert oder ggf. die Konzentrationen einzelner Komponenten im Medium handeln.

Das Feldgerät weist zumindest ein Gehäuse des Messaufnehmers und/oder des Messumformers auf. Das heißt das Gehäuse kann dem Messaufnehmer, dem Messumformer oder beiden Einheiten zugeordnet sein. So gibt es z.B. kompakte Temperaturmessgeräte oder magnetisch-induktive Durchflussmessgeräte bei welchen sowohl der Messumformer als auch der Messaufnehmer in einem Gehäuse realisiert sind. Häufiger jedoch treten Messumformer und Messaufnehmer beabstandet voneinander auf. So kann z.B. die Beabstandung durch einen Sensorhals erfolgen.

In dem vorgenannten Gehäuse sind typischerweise Elektronikbauteile angeordnet welche dem Messaufnehmer und/oder dem Messumformer zugeordnet sein können.

Solche Elektronikbauteile können beispielsweise Platinen und darauf angeordnete Bauteile, Planarspulen, herkömmliche Spulen, Widerstände, insbesondere Messwiderstände, Kabel und dergleichen sein.

Die vorbeschriebenen gattungsgemäßen Feldgeräte sind beispielsweise im Bereich der Durchflussmesstechnik an sich bekannt. Typischerweise werden solche Feldgeräte jedoch bei wechselnden Temperaturen kalibriert und unter ganz unterschiedlichen Temperaturbedingungen in der Praxis eingesetzt.

Zur Reduzierung von temperaturbedingten Materialspannungen sind die Elektronikbauteile erfindungsgemäß in einem Epoxid-Polymerschaum eingebettet, welcher ein Reaktionsprodukt ist aus einer selbstaufschäumenden Vergussmasse, insbesondere einer fließfähigen selbstaufschäumenden Vergussmasse, umfassend zumindest die folgenden Bestandteilen:
a) 25 bis 75 Gew.% eines Diglycidyletherharzes;
b) zumindest ein aminhaltiges Härtersystem umfassend eine Mannichbase; und
c) zumindest ein Treibmittel.

Die selbstaufschäumende Vergussmasse kann z.B. erst kurz vor dem Verschäumen der Elektronikbauteile bereitgestellt werden. Selbstaufschäumend bedeutet, dass die Vergussmasse von selbst bereits einen Polymerschaum ausbildet.

Ein Epoxid-Polymerschaum aus der vorgenannten selbstaufschäumenden Vergussmasse weist eine besonders optimierte Kompressibilität auf. Zudem sind auch Hinterschneidungen in einem Bauraum des Gehäuses umschäumt. Insgesamt kann besonders vorteilhaft das ganze freie Volumen des Gehäuses ausgeschäumt werden. Es handelt sich dabei jedoch bevorzugt um keine rein-oberflächliche Umschäumung der einzelnen Elektronikbauteile, sondern um eine Verschäumung, welche sich über die ganze Breite des Gehäuses erstreckt. Dadurch wird eine besonders vorteilhafte und isolierende Festlegung der Elektronikbauteile ermöglicht. Bevorzugt füllt der Polymerschaum zumindest 50 Vol.% des Gehäuses aus und besonders bevorzugt das gesamte Gehäuse.

Durch den Einsatz des vorgenannten speziellen Epoxid-Polymerschaums für die Einbettung von Elektronikbauteilen werden temperaturbedingte Materialspannungen, bei Temperaturen, wie sie in Feldgeräten in der Automatisierungstechnik auftreten, vorteilhaft reduziert. Zudem weist der Epoxid-Polymerschaum eine hohe Schaumstabilität auf, so dass die Elektronikbauteile nicht verrutschen. Zudem ist die Kraft des Schaumes auf die Elektronikbauteile gering, so dass diese nicht aufgrund von temperaturbedingten Spannungen beschädigt werden.

Vorteilhafte Ausgestaltungen der Erfindung sind Gegenstand der Unteransprüche.

Jeder Epoxid-Polymerschaum, welcher durch die vorgenannten Bestandteile herstellbar ist, kann im Rahmen der vorliegenden Erfindung eingesetzt werden.

Allerdings werden die Bestandteile der Vergussmasse zumeist nicht vollständig während des Aufschäumens aufgebraucht. Daher sind die Bestandteile der Vergussmasse auch im Epoxid-Polymerschaum nachweisbar. Jeder der Bestandteile a)-c) im Epoxid-Polymerschaum kann vorteilhaft mit einem Restgehalt von mehr als zumindest 100 ppm, vorzugsweise mit einem Restgehalt von zumindest 500 ppm, enthalten sein.

Das Diglycidyletherharz kann vorteilhaft ein Bisphenol-A- und/oder Bisphenol-F-Diglycidyletherharz sein.

Das Treibmittel kann vorteilhaft ein Polymethylhydrosiloxan sein, welches vorzugsweise bis zu 5 Gew.% in der Vergussmasse enthalten ist. Dieses Treibmittel kann in Kombination mit einem Amin und/oder einem Alkohol CO2 freisetzen. Dieses Amin oder der Alkohol kann beispielsweise durch den Härter bereitgestellt werden.

Es ist von Vorteil, wenn die Mannich-Base ein Reaktionsprodukt aus Para-Formaldehyd mit 4-tert-Butylphenol und/oder ein Reaktionsprodukt aus 4,4'-Isopropylidendiphenol mit 1,3-Phenylendimethanamin ist, welches vorzugsweise bis zu 15 Gew.% in der Vergussmasse enthalten ist. Diese beiden Reaktionsprodukte ermöglichen eine optimale Gelierzeit, welche ein Aufschäumen erlaubt. Sie ermöglichen eine optimale Porengröße von vorzugsweise 0,1 bis 0,5 mm (Bildanalyse) im Schaum und/oder eine definierte Konsistenz des Schaums bei einer bevorzugten Shorehärte von D 65-75 (nach ISO 868) .

Die Vergussmasse kann zudem vorteilhaft als weiteren Bestandteil
d) einen Reaktivverdünner enthalten, wobei der Reaktivverdünner vorzugsweise zumindest ein aliphatischer Diglycylether mit der allgemeinen Strukturformel: 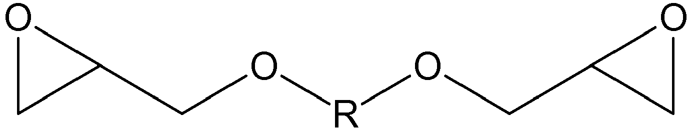 ,wobei R= Butyl- oder Hexyl- ist. Dadurch kann die Viskosität und das Fließverhalten des Schaums optimal eingestellt werden.

Die Vergussmasse kann vorteilhaft zudem als weiteren Bestandteil
e) einen flammhemmenden und/oder schaumstabilisierenden Füllstoff umfassen. Dies kann z.B. ein Aluminiumoxid und/oder ein Aluminiumhydroxid als einen flammenhemmenden Bestandteil enthalten, während der Einsatz von Siliziumoxid und/oder Calciumcarbonat eher schaumstabilisierende Eigenschaften bewirkt.

Die Vergussmasse kann zudem vorteilhaft als weiteren Bestandteil
f) ein Dispergieradditiv zur Stabilisation der Füllstoffe in der Vergussmasse aufweisen.

Die Vergussmasse, insbesondere das Härtersystem, kann vorteilhaft einen oder mehrere der folgenden weiteren Bestandteile enthalten:
g1) eine oder mehrere Fettsäuren, vorzugsweise mit einer Kettenlänge von größer als C18, besonders bevorzugt ungesättigte Fettsäuren mit einer Kettenlänge von größer als C18, insbesondere in Form von Dimeren und/oder Oligomeren;
g2) eines oder mehrere Reaktionsprodukte mit Tallöl-Fettsäuren und Polyaminen, vorzugsweise mit TETA und/oder TEPA;
g3) eines oder mehrere Polymere gebildet aus einer Reaktion von 4,4'-Isopropylidendiphenol und/oder 4,4'-Methylenbisphenol mit einem Reaktionsprodukt aus 1-Chlor-2,3-epoxypropan und 3-Aminomethyl-3,5,5-trimethylcyclohexan und/oder mit einem Reaktionsprodukt aus 1-Chlor-2,3-epoxypropan und Trimethylhexan-1,6-diamin;
g4) ein Trimethylhexan-1,6-diamin; 3-Aminomethyl-3,5,5-trimethylcyclohexan und/oder 1,3-Phenylendimethanamin;
g5) ein aromatischer Alkohol, vorzugsweise 4,4'-Isopropylidendiphenol, Benzylalkohol, Salicylsäure, 4-tert.-Butylphenol und/oder Phenol;
   und/oder
g6) eine Flüssigkeit, welche aus Cashew-Nussschalen gewonnen wurde.

Die Füllstoffe können vorteilhaft zwei unterschiedliche Körnungen aufweisen mit einer ersten Korngröße 0,3 bis 2,5 µm und einer zweiten Korngröße 15 bis 25 µm (Bestimmung durch Mastersize 3000 von Malvern), wobei das Verhältnis der Füllstoffe mit der ersten Korngröße zu den Füllstoffen mit der zweiten Korngröße zwischen 1 zu 3 und 2 zu 3. beträgt. Die Füllstoffe mit der höheren Korngröße stabilisieren den Schaum zusätzlich, während die Füllstoffe mit geringerer Korngröße das Ausfällen der Füllstoffe mit der höheren Korngröße verhindern.

Ein Verfahren zur Herstellung eines Feldgerätes der Automatisierungstechnik nach einem der vorhergehenden Ansprüche, umfasst die folgenden Schritte:
a) Anordnung von Elektronikbauteilen und ggf. weiterer Bauteile des Feldgerätes innerhalb eines Gehäuses eines Messaufnehmers und/oder Messwandlers
   Die weiteren Bauteile können dabei nicht-Elektronikbauteile sein, z.B. mechanische Bauteile.
b) Einbringen der selbstaufschäumenden Vergussmasse, insbesondere der fließfähigen selbstaufschäumenden Vergussmasse, in das Elektronikgehäuse unter Ausbildung eines Epoxid-Polymerschaumes; und
c) Verschließen, insbesondere mediumsdichtes Verschließen, des Gehäuses nach Ablauf einer Reaktionszeit zum Aufschäumen und Aushärten des Epoxid-Polymerschaumes und Bereitstellung des betriebsbereiten Feldgerätes.
Diese Bereitstellung kann beispielsweise auch das Aufspielen einer Software in das Feldgerät und ein Programmieren umfassen.

Nachfolgend wird der Gegenstand der Erfindung näher und mittels eines konkreten Ausführungsbeispiels erläutert.

In der Automatisierungstechnik, insbesondere in der Prozess-Automatisierungstechnik, werden vielfach Feldgeräte eingesetzt, die zur Erfassung und/oder Beeinflussung von Prozessvariablen dienen. Zur Erfassung von Prozessvariablen dienen Sensoren, die beispielsweise in Füllstandsmessgeräten, Durchflussmessgeräten, Druck- und Temperaturmessgeräten, pH-Redoxpotentialmessgeräten, Leitfähigkeitsmessgeräten, usw. integriert sind, welche die entsprechenden Prozessvariablen Füllstand, Durchfluss, Druck, Temperatur, pH-Wert bzw. Leitfähigkeit erfassen. Zur Beeinflussung von Prozessvariablen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann. Als Feldgeräte werden im Prinzip alle Geräte bezeichnet, die prozessnah eingesetzt werden und die prozessrelevante Informationen liefern oder verarbeiten. Im Zusammenhang mit der Erfindung werden unter Feldgeräten also auch Remote I/Os, Funkadapter bzw. allgemein elektronische Komponenten verstanden, die auf der Feldebene angeordnet sind. Eine Vielzahl solcher Feldgeräte wird von der Firma Endress + Hauser hergestellt und vertrieben.

Ein Feldgerät ist dabei insbesondere ausgewählt aus einer Gruppe bestehend aus Durchflussmessgeräten, Füllstandsmessgeräten, Druckmessgeräten, Temperaturmessgeräten, Grenzstandsmessgeräten und/oder Analysemessgeräten.

Durchflussmessgeräte sind insbesondere Coriolis-, Ultraschall-, Vortex-, thermische und/oder magnetisch induktive Durchflussmessgeräte.

Füllstandsmessgeräte sind insbesondere Mikrowellen-Füllstandsmessgeräte, Ultraschall-Füllstandsmessgeräte, zeitbereichsreflektometrische Füllstandsmessgeräte (TDR), radiometrische Füllstandsmessgeräte, kapazitive Füllstandsmessgeräte, induktive Füllstandsmessgeräte und/oder temperatursensitive Füllstandsmessgeräte.

Druckmessgeräte sind insbesondere Absolut-, Relativ- oder Differenzdruckgeräte.

Temperaturmessgeräte sind insbesondere Messgeräte mit Thermoelementen und temperaturabhängigen Widerständen.

Grenzstandsmessgeräte sind insbesondere Ultraschall-Grenzstandsmessgeräte und/oder kapazitive Grenzstandsmessgeräte.

Analysemessgeräte sind insbesondere pH-Sensoren, Leitfähigkeitssensoren, Sauerstoff- und Aktivsauerstoffsensoren, (spektro)-photometrische Sensoren, und/oder ionenselektive Elektroden.

Typischerweise unterscheidet man bei den vorgenannten Feldgeräten zwischen einer Messaufnehmereinheit und einer Messumformereinheit. Diese beiden Einheiten können voneinander beabstandet und durch einen sogenannten Sensorhals miteinander verbunden sein. Dies dient u.a. der thermischen Entkopplung des Messumformers von der Messstelle. Es sind allerdings auch Feldgeräte bekannt, in welchen die Messaufnehmereinheit und die Messumformereinheit in kompakter Bauweise in einem Gehäuse vereint sind.

Sowohl die Messaufnehmereinheit als auch die Messumformereinheit umfassen Elektronikbauteile. Typische Elektronikbauteile der Messaufnehmereinheit können Sensorelementen zugeordnet sein und können beispielsweise Spulen eines Magnetsystems, ein Messwiderstand zur Ermittlung der Mediumstemperatur, Ultraschallwandler eines Bimorphantriebs und/oder dergleichen sein. Elektronikbauteile der Messumformereinheit können z.B. Messverstärkerbauteile, Datenspeichereinheiten, CPU- bzw. Rechnereinheiten und/oder dergleichen sein.

Die Elektronikbauteile sind in einem Messaufnehmer- und/oder Messumformergehäuse angeordnet und sind in diesem Gehäuse in einer Schaummasse eingebettet.

Bei der Fixierung von Elektronikbauteilen im Gehäuse eines Feldgerätes mittels eines Epoxid-Polymerschaums müssen bestimmte Voraussetzungen beachtet werden.

Eine entscheidende Voraussetzung an den Epoxid-Polymerschaum ist die Kompressibilität des Polymerschaums. Diese wird benötigt um temperaturwechselbedingte Materialspannungen aufzunehmen, um die sensiblen Elektronikbauteile zu schützen. Diese Materialspannungen könnten u.a. zu Fehlmessungen führen und im Extremfall zu einem Ausfall des Elektronikbauteils.

Feldgeräte sind dabei aufgrund der zumeist zwingend notwendigen Kalibration einem Temperaturwechsel ausgesetzt. Ein Feldgerät der Prozessautomatisierung kann zudem in sehr unterschiedlichen Umgebungsbedingungen eingesetzt werden. So kann das Feldgerät beispielsweise sowohl zur Durchflussmessung von kryogenen Flüssigkeiten als auch von erhitzten Ölgemischen oder Dämpfen genutzt werden.

Idealerweise sollte der Epoxid-Polymerschaum auch eine thermische Isolation der Elektronikbauteile gegenüber der Gehäusewandung des die Elektronikbauteile umgebenden Gehäuses des Feldgerätes ermöglichen.

Nachfolgend wird die Ausgangszusammensetzung zur Herstellung des Epoxid-Polymerschaums näher erläutert. Der Epoxid-Polymerschaum wird aus einer selbstaufschäumenden Vergussmasse gebildet.

Die selbstaufschäumende Vergussmasse basiert auf einem Diglycidyletherharz, vorzugsweise auf einem Bisphenol-A- und/oder Bisphenol-F-Diglycidyletherharz. Dieses Basisharz ist vorzugsweise zwischen 25 bis 75 Gew.% in dem Eduktgemisch enthalten. Es kann sich somit bevorzugt um einen einkomponentigen Basisharz handeln, welcher zur Reaktion gebracht wird.

Das bevorzugte durchschnittliche Molekulargewicht des Diglycidyletherharzes beträgt mehr als 500 g/mol, vorzugsweise mehr als 700 g/mol.

Die bevorzugte Viskosität des Diglycidyletherharzes, gemäß DIN 53019, beträgt bei 25°C, 8 bis13 Pa*s.

Die selbstaufschäumende Vergussmasse umfasst zudem ein Treibmittel. Dieses Treibmittel ist bevorzugt Polymethylhydrosiloxan. Das Treibmittel, insbesondere Polymethylhydrosiloxan, kann vorzugsweise bis zu 5 Gew.%, in der Vergussmasse enthalten sein. In einer bevorzugten Ausführungsvariante der Erfindung ist Polymethylhydrosiloxan 0,3 und 2 Gew.% in der Vergussmasse enthalten.

Polymethylhydrosiloxan wird normalerweise als wasserabweisendes Agenz genutzt, im vorliegenden Fall wird allerdings eine Nebenreaktion dieses Agenz genutzt. Es reagiert mit einem Amin und/oder mit einem Alkohol unter CO2-Entwicklung. Bei diesem Amin kann es sich beispielsweise um ein in der Vergussmasse enthaltenes Amin handeln. Es hat sich vorteilhaft gezeigt, dass Polymethylhydrosiloxan bei dieser CO2-Entwicklung eine optimale Freisetzungsgeschwindigkeit aufweist.

Ein weiterer Bestandteil der Vergussmasse ist zudem ein Härtersystem umfassend zumindest ein Amin und/oder einen Alkohol. Dieses Härtersystem umfasst zudem eine Mannichbase. Das Amin und/oder der Alkohol kann bevorzugt in einer Vorreaktion mit dem Diglycidyletherharz und weiteren optionalen Inhaltsstoffen zur Reaktion gebracht werden. Anschließend wird die Mannichbase hinzugegeben, so dass es zu einer Gelbildung kommt.

Es hat sich überraschend gezeigt, dass durch die Zugabe der Mannichbase, die Aushärtezeit derart optimal eingestellt werden kann, dass es zu einer beginnenden Gelbildung während der Entwicklung des Treibmittels und zu einem Aushärten der Epoxidmasse kurz nach dem Aufschäumen kommt.

So kann das vollständige Aushärten der Vergussmasse zum Epoxid-Polymerschaum in einem bevorzugten Zeitraum von etwa 0,4 bis 2 Stunden, insbesondere innerhalb von 0,5 - 1 Stunde, erfolgen. Insgesamt wird durch den Einsatz der Mannich-Base in dem amin- und/oder alkoholhaltigen Härtersystem der Vergussmasse hinreichend Zeit zum Aufschäumen gegeben.

Die Vergussmasse kollabiert dabei nicht und sie wächst auch nicht zu schnell und bleibt hinreichend viskos, so dann auch Hinterfüllungen innerhalb eines Elektronikgehäuses mit dem Polymerschaum ausgefüllt werden, was bei vielen Schaumsystemen, z.B. bei Bauschaum, nicht der Fall ist.

Durch den Einsatz des vorgenannten Härtersystems kann somit ein kontrolliertes und gemächliches Aufsteigen des Polymerschaums aus der Vergussmasse erfolgen, ohne dass das System kollabiert. Die selbstschäumende Vergussmasse kann bei Raumtemperatur eingebracht werden.

Als Komponenten des Härtersystems weist die selbstschäumende Vergussmasse bevorzugt zumindest eine oder mehrere der nachfolgend-beschriebenen Komponenten auf
Als eine Komponente des Härtersystems kann eine oder mehrere Fettsäuren eingesetzt werden. Bevorzugte Fettsäuren weisen eine Kettenlänge von größer als C18 auf. Die Fettsäuren sind vorzugsweise ungesättigte Fettsäuren. Bevorzugt handelt es sich bei den Fettsäuren um Dimere und/oder Oligomere. Alternativ oder zusätzlich zu der Fettsäure kann als Komponente des Härtersystems auch eines oder mehrere Reaktionsprodukte mit Tallöl-Fettsäuren und Polyaminen, insbesondere TETA und/oder TEPA, eingesetzt werden. Die Konzentration der einen oder mehreren Fettsäuren oder des vorgenannten Reaktionsprodukts und/oder der Reaktionsprodukte in der Vergussmasse beträgt vorzugsweise bis zu 15 Gew%.

Alternativ oder zusätzlich kann als Komponente des Härtersystems in der selbstschäumenden Vergussmasse ein Polymer enthalten sein, welches gebildet ist aus 4,4'-Isopropylidendiphenol und/oder 4,4'-Methylenbisphenol welche Phenole mit 1-Chlor-2,3-epoxypropan reagieren, welches Epoxypropan mit 3-Aminomethyl-3,5,5-trimethylcyclohexan und/oder Trimethylhexan-1,6-diamin zur Reaktion gebracht wurde. Dieses vorgenannte Polymer kann bis zu 15 Gew.% in der Vergussmasse enthalten sein.

Eine weitere alternative oder zusätzliche Komponente des Härtersystems kann Trimethylhexan-1,6-diamin und/oder 3-Aminomethyl-3,5,5-trimethylcyclohexan und/oder 1,3-Phenylendimethanamin in der Vergussmasse mit bis zu 15 Gew.% enthalten sein.

Als weitere alternative oder optionale Komponente des Härtersystems kann ein Reaktionsprodukt von Para-Formaldehyd mit 4-tert-Butylphenol und/oder ein Reaktionsprodukt von 4,4'-Isopropylidendiphenol mit 1,3-Phenylendimethanamin enthalten sein. Diese Komponente kann ebenfalls bis zu 15 Gew.% in der Vergussmasse enthalten sein.

Weiterhin kann als alternative oder optionale Komponente des Härtersystems zumindest ein aromatischer Alkohol mit bis zu 15 Gew.% in der Vergussmasse enthalten sein. Dieser aromatische Alkohol kann bevorzugt ausgesucht sein aus folgender Gruppe: 4,4'-Isopropylidendiphenol, Benzylalkohol, Salicylsäure, 4-tert.-Butylphenol und/oder Phenol.

Weiterhin alternativ oder optional kann die Vergussmasse bis zu 10 Gew.% einer Flüssigkeit aufweisen, welche aus Cashew-Nussschalen gewonnen wurde.

Neben dem Basisharz, dem Härtersystem und dem Treibmittel kann die selbstschäumende Vergussmasse noch weitere Komponenten aufweisen, welche die Eigenschaften des Epoxid-Polymerschaumes zusätzlich verbessern.

So kann die Vergussmasse optional einen oder mehrere Reaktivverdünner aufweisen. Dieser Reaktivverdünner verringert die Viskosität der Vergussmasse um so ein besseres Anfließen der Vergussmasse in das Gehäuse und ein besseres Einbetten & Benetzen der Elektronikbauteile und der Gehäusewand zu ermöglichen. Ein Reaktivverdünner ist dabei nicht mit einem Verdünnungsmittel zu verwechseln, da vom Reaktivverdünner zumeist deutlich geringere Mengen benötigt werden um die Viskosität der Vergussmasse auf eine gewünschte Zielviskosität herabzusetzen. Als Reaktivverdünner für die selbstschäumende Vergussmasse kann im Rahmen der vorliegenden Erfindung bevorzugt ein aliphatischer Diglycylether oder mehrere aliphatische Diglycylether mit der allgemeinen Strukturformel: 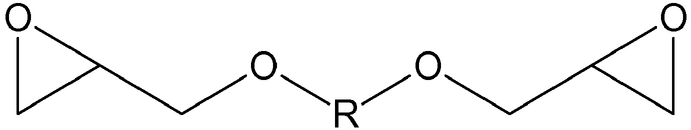 Verwendet werden, wobei R= Butyl oder Hexyl sein kann

Die selbstschäumende Vergussmasse kann optional Füllstoffe enthalten. Diese Füllstoffe dienen vorwiegend dem Zweck einer flammenhemmenden Wirkung und/oder einer zusätzlichen Stabilisierung des Schaumes und können vorzugsweise bis zu 70 Gew.%, besonders bevorzugt von 50 bis 70 Gew.%, in der Vergussmasse enthalten sein. Diese Füllstoffe umfassen eine oder mehrere der folgenden Verbindungen: Siliziumdioxid, Calciumcarbonat, Aluminiumhydroxid und/oder Aluminiumoxid.

In einer bevorzugten Ausführungsvariante enthält die Vergussmasse Füllstoffe in zumindest zwei verschiedenen Körnungsgrößen. Eine erste Körnungsgröße umfasst nach einer Messung durch Laserbeugung einen D₁₀ von 0,5 µm, einen D₅₀ von 1 µm und einen D₉₀ von 2,4 µm. Füllstoffe mit dieser ersten Körnungsgröße sind in einer bevorzugten Ausführungsvariante zumindest zu 10 Gew.% in der Vergussmasse enthalten.

Eine zweite Körnungsgröße umfasst nach einer Messung durch Laserbeugung einen D₁₀ von 3 µm, einen D₅₀ von 20 µm und einen D₉₀ von 50 µm. Füllstoffe mit dieser zweiten Körnungsgröße sind in einer bevorzugten Ausführungsvariante zumindest zu 30 Gew.% in der Vergussmasse enthalten.

Der Füllstoff mit dieser ersten Körnungsgröße ist gegenüber dem Füllstoff mit der zweiten Körnungsgröße zu 1 zu 3 bis 2 zu 3 % in der Vergussmasse enthalten
Die Verwendung von Füllstoffen mit zumindest zwei Korngrößen erhöht zusätzlich die Stabilität des Polymerschaums und verringert die Sedimentation der Füllstoffe mit der größeren Körnung.

Weiterhin optional kann in der selbstschäumenden Vergussmasse ein Dispersionsadditiv eingesetzt werden, welches die Flockulation von Füllstoffen in der Vergussmasse kontrolliert. Derartige Dispergieradditive verhindern insbesondere das Absetzen und das Ablaufen von Füllstoffen aus der Vergussmasse. Als bevorzugtes Dispergieradditiv kann eine oder mehrere Polycarbonsäure-Polymere eingesetzt werden. Dabei empfiehlt sich bevorzugt eine Konzentration an Dispergieradditiv 5 Gew.% oder weniger.

Nachfolgend wird ein konkretes Ausführungsbeispiel genannt, welches im Rahmen der vorliegenden Erfindung als selbstschäumende Vergussmasse in ein Gehäuse eines Messaufnehmers und/oder eines Messumformers eingebracht wird und unter Einbettung von im Gehäuse befindlichen Elektronik-Bauteile zu einer Epoxid-Polymerschaum aushärtet.

Nachfolgend wird ein Beispiel für eine konkrete Vergussmasse gegeben:

**Vergussmasse 1 (130 Anteile)**

| | |
|---|---|
| Epikote Resin 169 | 40 |
| Heloxy Modifier BD | 5 |
| BYK-P 105 | 2 |
| Bluesil WR 68 | 1 |
| Apyral 2E | 60 |
| Aradur HY 842 | 10 |
| D.E.H. 615 | 5 |
| Addukt aus Epikote Resin 169 (40 MT) mit Vestamin TMD (100 MT) | 7 |

Dabei ist Epikote Resin 169 ein Diglycidylether-Basisharz;
Heloxy Modifier BD ein aliphatischer Diglycidylether als ein Reaktivverdünner,
BYK-P 105 ein Polycarbonsäurepolymer als ein Dispersionsadditiv, Bluesil WR 68 ein Polymethylhydrosiloxan als Treibmittel,
Apyral 2E ein flammhemmender Füllstoff in Form von Aluminiumhydroxid,
Aradur HY 842 ein Polyamidoamin-Härtungsmittel als Teil eines Härtungssystems, D.E.H. 615 eine Mannich-Base als Teil des Härtungssystems,
und ein Reaktionsprodukt aus Epikote Resin 169 (40 Gewichtsanteile) mit Vestamin TMD (100 Gewichtsanteile) als Teil des Härtungssystems.

Letzeres wird vor der Zugabe zur Vergussmasse miteinander in Reaktion gebracht wobei ein Teil der zugegebenen Überschuss-Menge an Vestamin TMD mit dem Basisharz reagiert. Ein Großteil an Vestamin reagiert nicht mit dem Basisharz und liegt auch in nachweisbaren Mengen nach der Reaktion zum Epoxid-Polymerschaum, ebenso wie auch die Mannich-Base, in diesem Polymerschaum vor.

Die selbstaufschäumende Vergussmasse wird erst sehr kurz, vorzugsweise weniger als 5 Minuten, beispielsweise 3 Minuten, vor ihrem Verguss mit den Elektronikbauteilen bereitgestellt, indem das Treibmittel und/oder die einzelne Härterkomponenten zu dem Diglycidyletherharz zugegeben werden. Es erfolgt eine Gelbildung bei gleichzeitigem Aufschäumen und es kann sich in einem Zeitraum von beispielsweise 40 Minuten ein mit Epoxid-Polymerschaum ausgefülltes Gehäuse ergeben. Bei Verwendung von Polymethylhydrosiloxan als Treibmittel kann die Schaumbildung vorteilhaft bei normalen Umgebungstemperaturen zwischen 20 bis 40 °C erfolgen.

In einer bevorzugten Ausführungsvariante ist die Vergussmasse bisphenolhaltig jedoch frei von weiteren Phenolen und/oder Phenolderivaten.

## Patentansprüche

1. Feldgerät der Automatisierungstechnik umfassend einen Messaufnehmer zur Ermittlung eines Messsignals und einem Messumformer zur Ausgabe einer aus dem Messsignal ermittelten physikalischen Größe eines Mediums in einem Behältnis und/oder einem Rohr und/oder einer aus dem Messsignal ermittelten Stoffeigenschaft des Mediums, wobei das Feldgerät zumindest ein Gehäuse des Messaufnehmers und/oder des Messumformers aufweist, in welchem Elektronikbauteile des Messaufnehmers und/oder des Messumformers angeordnet sind,
**dadurch gekennzeichnet, dass** die Elektronikbauteile in einem Epoxid-Polymerschaum eingebettet sind, welcher ein Reaktionsprodukt ist aus einer selbstaufschäumenden Vergussmasse umfassend zumindest die folgenden Bestandteilen:
a) 25 bis 75 Gew.% eines Diglycidyletherharzes;
b) zumindest ein aminhaltiges Härtersystem umfassend eine Mannichbase; und
c) zumindest ein Treibmittel.

2. Feldgerät nach Anspruch 1, **dadurch gekennzeichnet, dass** jeder der Bestandteile a)-c) im Epoxid-Polymerschaum mit einem Restgehalt von mehr als zumindest 100 ppm, vorzugsweise mit einem Restgehalt von zumindest 500 ppm, enthalten ist.

3. Feldgerät nach Anspruch 1 oder 2, **dadurch gekennzeichnet, dass** der Diglycidyletherharz ein Bisphenol-A- und/oder Bisphenol-F-Diglycidyletherharz ist.

4. Feldgerät nach einem der vorhergehenden Ansprüche, **dadurch gekennzeichnet, dass** das Treibmittel ein Polymethylhydrosiloxan ist, welches vorzugsweise bis zu 15 Gew.% in der Vergussmasse enthalten ist.

5. Feldgerät nach einem der vorhergehenden Ansprüche, **dadurch gekennzeichnet, dass** die Mannich-Base ein Reaktionsprodukt aus Para-Formaldehyd mit 4-tert-Butylphenol und/oder ein Reaktionsprodukt aus 4,4'-Isopropylidendiphenol mit 1,3-Phenylendimethanamin ist, welches vorzugsweise bis zu 15 Gew.% in der Vergussmasse enthalten ist.

6. Feldgerät nach einem der vorhergehenden Ansprüche, **dadurch gekennzeichnet, dass** die Vergussmasse zudem als weiteren Bestandteil
d) einen Reaktivverdünner enthält, wobei der Reaktivverdünner vorzugsweise zumindest ein aliphatischer Diglycylether mit der allgemeinen Strukturformel: 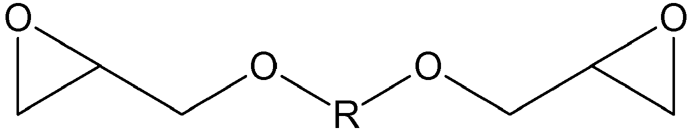 ,wobei R= Butyl- oder Hexyl- sein kann, ist.

7. Feldgerät nach einem der vorhergehenden Ansprüche, **dadurch gekennzeichnet, dass** die Vergussmasse zudem als weiteren Bestandteil
e) einen flammhemmenden und/oder schaumstabilisierenden Füllstoffe umfasst, welches vorzugsweise ein Aluminiumoxid, ein Aluminiumhydroxid, ein Siliziumoxid und/oder ein Calciumcarbonat ist.

8. Feldgerät nach Anspruch 7, **dadurch gekennzeichnet, dass** die Vergussmasse zudem als weiteren Bestandteil
f) ein Dispergieradditiv zur Stabilisation der Füllstoffe in der Vergussmasse aufweist.

9. Feldgerät nach einem der vorhergehenden Ansprüche, **dadurch gekennzeichnet, dass** die Vergussmasse, insbesondere das Härtersystem, einen oder mehrere der folgenden weiteren Bestandteile enthält:
g1) eine oder mehrere Fettsäuren, vorzugsweise mit einer Kettenlänge von größer als C18, besonders bevorzugt ungesättigte Fettsäuren mit einer Kettenlänge von größer als C18, insbesondere in Form von Dimeren und/oder Oligomeren;
g2) eines oder mehrere Reaktionsprodukte mit Tallöl-Fettsäuren und Polyaminen, vorzugsweise mit TETA und/oder TEPA, eingesetzt werden;
g3) eines oder mehrere Polymere gebildet aus einer Reaktion von 4,4'-Isopropylidendiphenol und/oder 4,4'-Methylenbisphenol mit einem Reaktionsprodukt aus 1-Chlor-2,3-epoxypropan und 3-Aminomethyl-3,5,5-trimethylcyclohexan und/oder mit einem Reaktionsprodukt aus 1-Chlor-2,3-epoxypropan und Trimethylhexan-1,6-diamin;
g4) ein Trimethylhexan-1,6-diamin; 3-Aminomethyl-3,5,5-trimethylcyclohexan und/oder 1,3-Phenylendimethanamin;
g5) ein aromatischer Alkohol, vorzugsweise 4,4'-Isopropylidendiphenol, Benzylalkohol, Salicylsäure, 4-tert.-Butylphenol und/oder Phenol;
und/oder
g6) eine Flüssigkeit, welche aus Cashew-Nussschalen gewonnen wurde.

10. Feldgerät nach einem der vorhergehenden Ansprüche, **dadurch gekennzeichnet, dass** die Füllstoffe zwei unterschiedliche Körnungen aufweisen mit einer ersten Korngröße 0,3 bis 2,5 µm und einer zweiten Korngröße 15 bis 25µm. wobei das Verhältnis der Füllstoffe mit der ersten Korngröße zu den Füllstoffen mit der zweiten Korngröße zwischen 1 zu 3 und 2 zu 3. beträgt.

11. Verfahren zur Herstellung eines Feldgerätes der Automatisierungstechnik nach einem der vorhergehenden Ansprüche, umfassend die folgenden Schritte:
a) Anordnung von Elektronikbauteilen und ggf. weiterer Bauteile des Feldgerätes innerhalb eines Gehäuses eines Messaufnehmers und/oder Messwandlers;
b) Einbringen der fließfähigen selbstaufschäumenden Vergussmasse in das Elektronikgehäuse unter Ausbildung eines Epoxid-Polymerschaumes; und
c) Verschließen, insbesondere mediumsdichtes Verschließen, des Gehäuses nach Ablauf einer Reaktionszeit zum Aufschäumen und d) Aushärten des Epoxid-Polymerschaumes und Bereitstellung des betriebsbereiten Feldgerätes.

## Claims

1. Field device used in automation engineering comprising a sensor for the determination of a measuring signal, and a transmitter designed to output a measured variable - determined from the measuring signal - of a medium in a vessel and/or a pipe and/or a material property of the medium determined from the measuring signal, wherein the field device features at least a housing of the sensor and/or transmitter in which electronic components of the sensor and/or of the transmitter,
**characterized in that**
the electronic components are embedded in an epoxy polymer foam which is a reaction product from a self-foaming potting compound comprising at least the following components:
a) 25 to 75% in weight of a diglycidyl ether resin;
b) at least a hardener system containing amines, comprising a Mannich base; and
c) at least a blowing agent.

2. Field device as claimed in Claim 1, **characterized in that** each of the components a)-c) is contained in the epoxy polymer foam with a residual content greater than at least 100 ppm, preferably with a residual content of at least 500 ppm.

3. Field device as claimed in Claim 1 or 2, **characterized in that** the diglycidyl ether resin is a bisphenol A and/or bisphenol F diglycidyl ether resin.

4. Field device as claimed in one of the previous claims **characterized in that** the blowing agent is a polymethylhydrosiloxane, which is preferably contained up to 15 % in weight in the potting compound.

5. Field device as claimed in one of the previous claims **characterized in that** the Mannich base is a reaction product from paraformaldehyde with 4-tert-butylphenol and/or a reaction product from 4,4' isopropylidenediphenol with 1,3 phenylenedimethanamine, which is preferably contained up to 15 % in weight in the potting compound.

6. Field device as claimed in one of the previous claims **characterized in that** the potting compound contains, as a further component,
d) a reactive diluent, wherein said reactive diluent is preferably at least an aliphatic diglycyl ether with the following general structure formula: 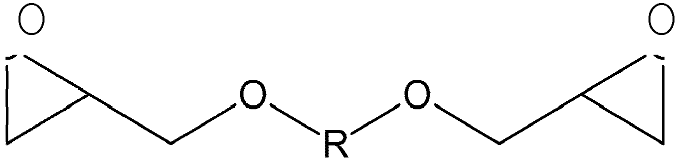 where R can represent butyl or hexyl.

7. Field device as claimed in one of the previous claims **characterized in that** the potting compound contains, as a further component,
e) a flame-retarding and/or foam-stabilizing filler which is preferably an aluminum oxide, a aluminium hydroxide, a silicon oxide and/or a calcium carbonate.

8. Field device as claimed in Claim 7, **characterized in that** the potting compound contains, as a further component,
f) a dispersion additive to stabilize the fillers in the potting compound.

9. Field device as claimed in one of the previous claims, **characterized in that** the potting compound, particularly the hardener system, contains one or more of the following components:
g1) one or more fatty acids, preferably with a chain length greater than C18, particularly preferably unsaturated fatty acids with a chain length greater than C18, particularly in the form of dimers and/or oligomers;
g2) one or more reaction products with tall oil fatty acids and polyamines, preferably with TETA and/or TEPA, are used;
g3) one or more polymers formed from a reaction of 4,4' isopropylidenediphenol and/or 4,4' methylenebisphenol with a reaction product of 1-chloro-2,3-epoxypropane and 3-aminomethyl-3,5,5-trimethylcyclohexane and/or with a reaction product of 1-chloro-2,3-epoxypropane and trimethylhexane-1,6-diamine;
g4) a trimethylhexane-1,6-diamine; 3-aminomethyl-3,5,5-trimethylcyclohexane and/or 1,3-phenylenedimethanamine;
g5) an aromatic alcohol, preferably 4,4'-isopropylidenediphenol, benzyl alcohol, salicylic acid, 4-tert-butylphenol and/or phenol; and/or
g6) a liquid which can be obtained from cashew nut shells.

10. Field device as claimed in one of the previous claims, **characterized in that** the fillers have two different grains, with a first grain size 0.3 to 2.5 µm and a second grain size 15 to 25 µm, wherein the ratio of the fillers with the first grain size to the second grain size is between 1 to 3 and 2 to 3.

11. Procedure designed to manufacture a field device used in automation engineering as claimed in one of the previous claims, comprising the following steps:
a) Arrangement of electronic components and, where applicable, other components of the field device in the housing of a sensor and/or a transmitter;
b) Introduction of the flowable self-foaming potting compound into the electronics housing with the formation of an epoxy polymer foam; and
c) Sealing, particularly medium-tight sealing, of the housing following a reaction time for foaming and
d) Hardening of the epoxy polymer foam and provision of the operational field device.

## Revendications

1. Appareil de terrain de la technique d'automatisation comprenant un capteur destiné à la détermination d'un signal de mesure, et un transmetteur destiné à la mesure d'une grandeur physique - déterminée à partir du signal de mesure - d'un produit dans un réservoir et/ou un tube et/ou d'une propriété matérielle du produit déterminée à partir du signal de mesure, l'appareil de terrain comportant au minimum un boîtier de capteur et/ou de transmetteur, dans lequel sont disposés les composants électroniques du capteur et/ou du transmetteur, **caractérisé**
**en ce que** les composants électroniques sont enrobés dans une mousse de polymère époxy, laquelle est un produit de réaction à partir d'une masse d'enrobage auto-moussante avec au minimum les composants suivants :
a) 25 à 75 % en poids d'une résine d'éther diglycidylique ;
b) au moins un système durcisseur contenant de l'amine, comprenant une base de Mannich ; et
c) au moins un produit moussant.

2. Appareil de terrain selon la revendication 1, **caractérisé en ce que** chacun des composants a)-c) est contenu dans la mousse de polymère époxy avec une teneur résiduelle supérieure à au moins 100 ppm, de préférence avec une teneur résiduelle d'au moins 500 ppm.

3. Appareil de terrain selon la revendication 1 ou 2, **caractérisé en ce que** la résine d'éther diglycidylique est une résine de bisphénol A et/ou de bisphénol F à base d'éther diglycidylique.

4. Appareil de terrain selon l'une des revendications précédentes, **caractérisé en ce que** l'agent moussant est un polyméthylhydrosiloxane, qui est de préférence contenu jusqu'à 15 % en poids dans la masse d'enrobage.

5. Appareil de terrain selon l'une des revendications précédentes, **caractérisé en ce que** la base de Mannich est un produit de réaction du para-formaldéhyde avec du 4-tert-butylphénol et/ou un produit de réaction du 4,4'-isopropylidènediphénol avec du 1,3-phénylènediméthanamine, qui est de préférence contenu jusqu'à 15 % en poids dans la masse d'enrobage.

6. Appareil de terrain selon l'une des revendications précédentes, **caractérisé en ce que** la masse d'enrobage contient, comme composant supplémentaire
d) un diluant réactif, lequel diluant réactif contient de préférence au moins un éther diglycylique aliphatique présentant la structure générale suivante : 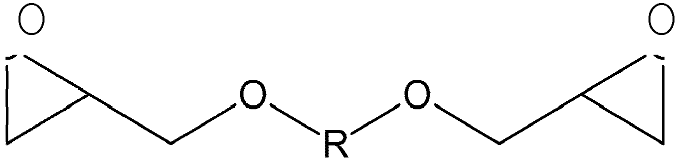 dans laquelle R peut représenter un butyle- ou un hexyle-.

7. Appareil de terrain selon l'une des revendications précédentes, **caractérisé en ce que** la masse d'enrobage comprend, en outre, comme composant supplémentaire
e) des charges retardatrices de flamme et/ou stabilisatrices de mousse, lequel composant est de préférence un oxyde d'aluminium, un hydroxyde d'aluminium, un oxyde de silicium et/ou un carbonate de calcium.

8. Appareil de terrain selon la revendication 7, **caractérisé en ce que** la masse d'enrobage comprend, en outre, comme composant supplémentaire
f) un additif dispersant destiné à stabiliser les charges dans la masse d'enrobage.

9. Appareil de terrain selon l'une des revendications précédentes, **caractérisé en ce que** la masse d'enrobage, notamment le système durcisseur, contient un ou plusieurs des autres composants suivants :
g1) un ou plusieurs acides gras, de préférence d'une longueur de chaîne supérieure à C18, particulièrement de préférence des acides gras insaturés d'une longueur de chaîne supérieure à C18, notamment sous forme de dimères et/ou d'oligomères ;
g2) un ou plusieurs produits de réaction avec des acides gras de tallol et des polyamines, utilisés de préférence avec la TETA et/ou la TEPA ;
g3) un ou plusieurs polymères formés à partir d'une réaction de 4,4'-isopropylidènediphénol et/ou de 4,4'-méthylènebisphénol avec un produit de réaction du 1-chloro-2,3-époxypropane et du 3-aminométhyl-3,5,5-triméthylcyclohexane et/ou avec un produit de réaction du 1-chloro-2,3-époxypropane et du triméthylhexane-1,6-diamine ;
g4) un triméthylhexane-1,6-diamine ; 3-aminométhyl-3,5,5-triméthylcyclohexane et/ou 1,3-phénylènediméthanamine ;
g5) un alcool aromatique, de préférence le 4,4'-isopropylidènediphénol, l'alcool benzylique, l'acide salicylique, le 4-tert-butylphénol et/ou le phénol ; et/ou
g6) un liquide obtenu à partir de coquilles de noix de cajou.

10. Appareil de terrain selon l'une des revendications précédentes, **caractérisé en ce que** les charges présentent deux granularités différentes, avec une première grosseur de grain de 0,3 à 2,5 µm et une deuxième grosseur de grain de 15 à 25 µm, le rapport entre les charges de la première grosseur de grain et les charges de la deuxième grosseur de grain étant compris entre 1 à 3 et 2 à 3.

11. Procédé destiné à la fabrication d'un appareil de terrain de la technique d'automatisation selon l'une des revendications précédentes, comprenant les étapes suivantes :
a) Disposition de composants électroniques et, le cas échéant, de composants supplémentaires de l'appareil de terrain à l'intérieur d'un boîtier d'un capteur et/ou d'un transmetteur ;
b) Introduction de la masse d'enrobage fluide et auto-moussante dans le boîtier de l'électronique avec formation d'une mousse de polymère époxy ; et
c) Obturation, notamment obturation étanche au produit, du boîtier après l'écoulement d'un temps de réaction pour le moussage et
d) Durcissement de la mousse de polymère époxy et mise à disposition de l'appareil de terrain opérationnel.
